(19) Europäisches Patentamt

European Patent Office

Office européen des brevets

(11) **EP 1 722 414 A2**

(12) **EUROPEAN PATENT APPLICATION**

(43) Date of publication:
15.11.2006 Bulletin 2006/46

(51) Int Cl.:
*H01L 23/498* (2006.01)   *H01L 25/11* (2006.01)
*H01L 23/66* (2006.01)   *H05K 1/18* (2006.01)

(21) Application number: 06251749.5

(22) Date of filing: 30.03.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 13.05.2005 US 680727 P
31.10.2005 US 263115

(71) Applicant: STMicroelectronics, Inc.
Carrollton, TX 75006-5039 (US)

(72) Inventor: Rotay, Craig J.
Montgomery Country, PA 19403-1819 (US)

(74) Representative: Style, Kelda Camilla Karen et al
Page White & Farrer
Bedford House
John Street
London, WC1N 2BF (GB)

(54) **Improved reliability and improved frequency response package for extremely high power density transistors**

(57)   A high power density transistor structure includes a transistor package capable of housing a high power density transistor. The transistor package has a package insulator and a plurality of transistor leads. Each of the transistor leads has a far end, a near end and a lead periphery. The high power density transistor structure also includes a solder lock located on at least one of the transistor leads. At least a portion of the solder lock is attachable to a printed circuit board (PCB). At least a portion of the lead periphery of each transistor lead is attachable to at least one of the PCB and the package insulator.

*FIG. 5*

EP 1 722 414 A2

Description

## CROSS-REFERENCE TO RELATED APPLICATIONS

This patent application claims priority under 35 U.S.C. § 119(e) to U.S. Provisional Patent Application No. 60/680,727 entitled "Improved Reliability and Improved Frequency Response Package for Extremely High Power Density Transistors" filed on May 13, 2005, which is hereby incorporated by reference.

## TECHNICAL FIELD

This disclosure is generally directed to high power density transistors and more specifically to systems and methods for increasing the periphery of device leads while improving frequency response.

## BACKGROUND

It is well known in the field of high frequency design that semiconductor packaging necessarily introduces parasitic inductance by virtue of electrical connections between a semiconductor chip and outside circuitry. The connections are normally formed of wirebonds and conductive traces that collectively pass electrical current from the inside of the package to external leads.

Due to the extreme high power density of certain transistors, thermal and electrical stress results in eventual mechanical fatigue and ultimately failure of one or both critical interfaces to which lead frame conductors are attached. Such failures result in degraded performance and possibly destruction of the semiconductor. At the same time, in practice it is also often necessary to minimize parasitic inductance in order to maximize the operating frequency capability of the overall structure. Parasitic inductance, which is electrically connected in series with the flow of electrical current, forms a low-pass filter network that tends to oppose the flow of current as the operating frequency increases. At some frequency, determined by the application, the impedance to current flow reaches a critical point at which there is a detrimental impact on system performance. It is often necessary to mitigate the effects of various elements in the electrical path in order to optimize the overall parasitic inductance and increase the maximum operating frequency of the system.

## SUMMARY

This disclosure provides a system and method improved reliability and improved frequency response package for extremely high power density transistors.

In a first embodiment, a high power density transistor structure includes a transistor package capable of housing a high power density transistor. The transistor package has a package insulator and a plurality of transistor leads. Each of the transistor leads has a far end, a near end and a lead periphery. A solder lock is located on at least one of the transistor leads. At least a portion of the solder lock is attachable to a printed circuit board (PCB). At least a portion of the lead periphery of each transistor lead is attachable to at least one of the PCB and the package insulator.

In a second embodiment, a method for increasing frequency response and mechanical integrity of a high power density transistor having a plurality of leads includes: soldering a portion of a transistor lead periphery of at least one of the leads to a printed circuit board (PCB), soldering a portion of a solder lock of at least one of the leads onto the PCB, and brazing a portion of the transistor lead periphery of at least one of the leads to a transistor package insulator.

In a third embodiment, a high power density transistor structure includes a first transistor package capable of housing a first high power density transistor and a second transistor package capable of housing a second high power density transistor. The first transistor package has a first package insulator and a plurality of first transistor leads, and the second transistor package has a second package insulator and a plurality of second transistor leads. Each of the transistor leads has a far end, a near end and a lead periphery. The far end of at least one transistor lead has a width greater than a width of the near end of the transistor lead. The transistors are electrically connected by the far ends of at least one lead from the first transistor package and at least one lead from the second transistor package.

Other technical features may be readily apparent to one skilled in the art from the following figures, descriptions and claims.

## BRIEF DESCRIPTION OF THE DRAWINGS

For a more complete understanding of this disclosure and its features, reference is now made to the following description, taken in conjunction with the accompanying drawings, in which:
FIGURE 1 illustrates an example high power density transistor package of the prior art;
FIGURE 2 illustrates the physical dimensions of the example high power density transistor package of the prior art depicted in FIGURE 1;

FIGURES 3A, 3B and 3C illustrate example high power density transistor packages according to embodiments of this disclosure;

FIGURE 4 illustrates the example high power density transistor package depicted in FIGURE 3C;

FIGURE 5 illustrates physical dimensions of the example high power density transistor package according to the embodiment depicted in FIGURES 3C and 4;

FIGURE 6 illustrates an example application for a high power density transistor package according to one embodiment of this disclosure; and

FIGURE 7 illustrates an example method of using a high power density transistor package according to one embodiment of this disclosure.

## DETAILED DESCRIPTION

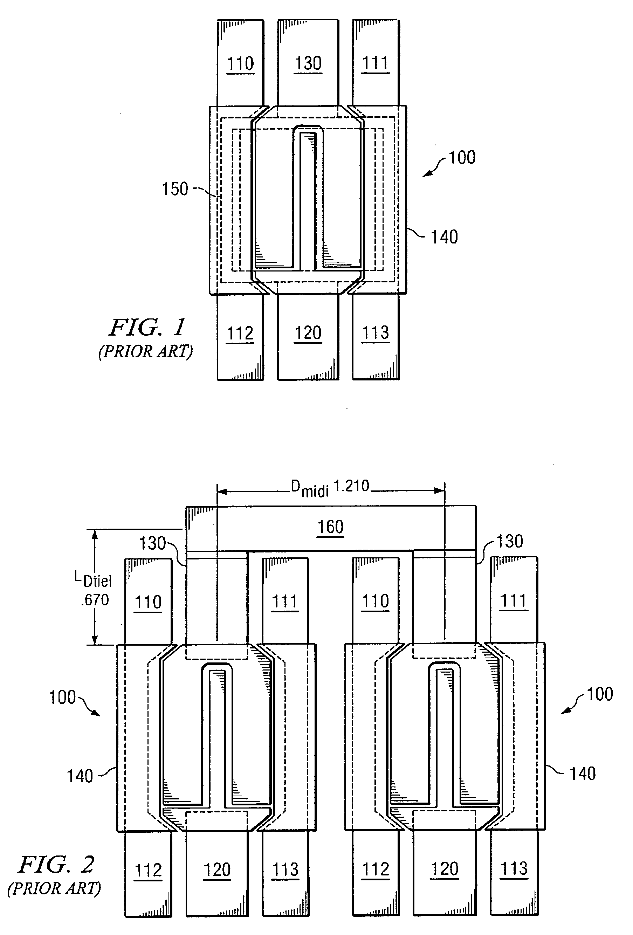

FIGURE 1 illustrates an example high power density transistor package 100 of the prior art having four source (or common) leads 110, 111, 112 and 113, gate (or input) lead 120 and drain (or output) lead 130. Each lead 110, 111, 112, 113, 120 and 130 provides electrical connectivity to a transistor associated with transistor package 100, regardless of whether transistor package 100 is, for example, for a bipolar transistor or a MOSFET. Transistor package 100 includes package insulator 140, upon which the transistor is attached, and protective cover 150. Protective cover 150 serves to protect components inside transistor package 100. In some cases, transistor leads 110, 111, 112, 113, 120 and 130 are soldered to a printed circuit board (PCB) and brazed to the package insulator 140. Prior art transistor packages 100 are generally 1.0 x 1.0 inch (in.) square in dimension, while leads 110, 111, 112, 113, 120 and 130 have an elongated, rectangular shape of the same size and dimension. The complete transistor package 100 is normally mechanically attached to a heat spreader by means of the back surface of package insulator 140.

In practice, many applications require two high power density transistor packages 100 be placed adjacent to one another on a PCB, such that the electrical length between the two is minimized. FIGURE 2 illustrates the physical dimensions and relative proximity of two adjacently placed prior art transistor packages 100. The distance ($D_{mid1}$) between the centers of the output leads 130 of the two packages 100 is approximately 1.210 in. In practice, most prior art high power density transistor packages 100 typically require that a standard periphery lead length be available for soldering and brazing. For example, $P_{Dlead}$, which designates the length of the edge periphery of output lead 130 (or input lead 120) available for soldering to the PCB, is approximately equal to 1.235 in. On the other hand, $P_{Dbraze}$, which designates the length of the edge periphery of output lead 130 (or input lead 120) available for brazing to package insulator 140, is approximately equal to 0.445 in. In addition, Psleaa, which designates the combined lengths of the edge peripheries of common leads 110, 111, 112 and 113 available for soldering to the PCB, is approximately equal to 4.760 in. Finally, $P_{Sbraze}$, which designates the length of the combined lengths of the edge peripheries of common leads 110, 111, 112 and 113 available for brazing to the package insulator 140, is approximately equal to 4.230 in.

FIGURE 2 also illustrates various electrical lengths for prior art transistor packages 100. Taking into account any spacing prerequisites, the minimum lead length to externally connect a prior art transistor package 100 to a tie point 160 ($L_{Dtie1}$) is approximately 0.670 in. Thus, the electrical length between output leads 130 (i.e., the total path length required to connect output lead 130 of the first transistor package to the output lead 130 of the second transistor package, $L_{DLFAD1}$) is determined using Equation 1:

$$L_{Dlead1} = 2\ L_{Dtie1} + D_{mid1} = 2\ *\ (0.670\ in.)\ +\ 1.210\ in.\ =\ 2.550\ in.\ (1)$$

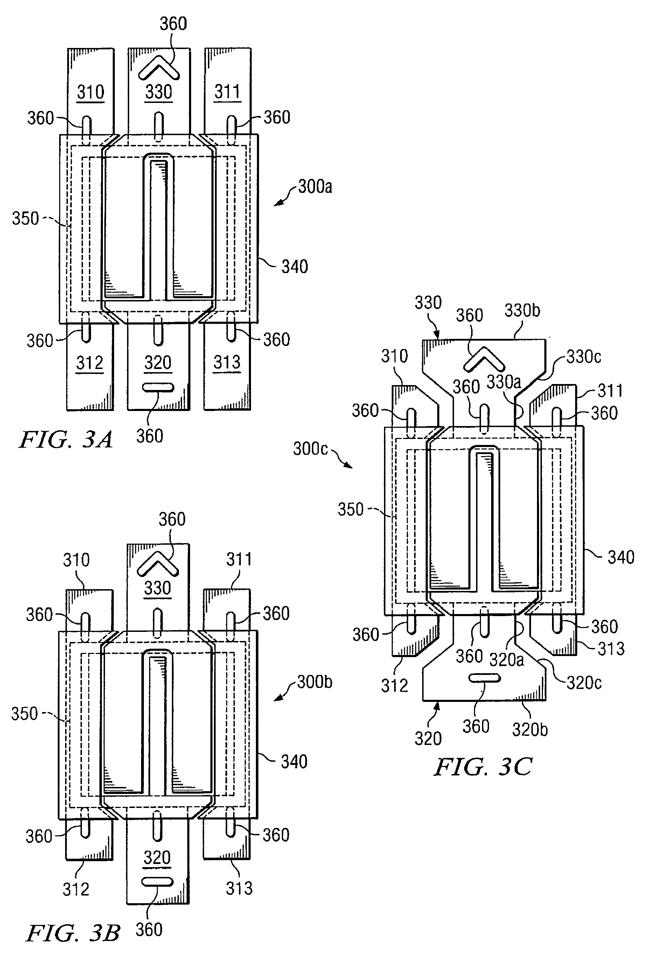

FIGURE 3A depicts transistor package 300a in accordance with a first embodiment of this disclosure. Transistor package 300a typically houses a power semiconductor having four source (or common) leads 310, 311, 312 and 313, gate (or input) lead 320, and drain (or output) lead 330. Transistor package 300a also includes package insulator 340 and protective cover 350. Transistor package 300a may be 1.0 x 1.0 in. square in dimension, although it could have any other suitable dimensions. Each lead 310, 311, 312, 313, 320 and 330 may be approximately the same size and shape. The periphery of leads 310, 311, 312, 313, 320 and 330 may be soldered to a PCB with tin lead (SnPb) solder and brazed to the package insulator 340 with copper silver (CuAg) brazing. Each lead 310, 311, 312, 313, 320 and 330 may include one or more solder locks 360. Solder locks 360 are physical cut-outs or holes on a lead and may be used as a soldering or brazing joint. Solder locks 360 thus serve to significantly increase the edge periphery available for soldering or brazing. Each solder lock 360 may be strategically placed to improve the surface contact of leads 310, 311, 312, 313, 320 and 330 to the PCB and to increase the periphery of transistor package 300a, thereby adding mechanical strength at the interface of leads 310, 311, 312, 313, 320 and 330 to PCB. Also, mechanical strength at the interface of leads 310, 311, 312, 313, 320 and 330 to package insulator 340 may be gained by redistributing and reducing mechanical stresses. Thus, the reliability of transistor package 300a is also improved. In addition, improvements in high power density applications, where high power dissipation results in thermal cycling of the entire assembly and exhibits severe mechanical stress upon the soldered and brazed lead frame interfaces, are also achieved.

FIGURE 3B depicts transistor package 300b in accordance with a second embodiment of this disclosure. Transistor package 300b typically houses a power semiconductor having four source (or common) leads 310, 311, 312 and 313, gate (or input) lead 320, and drain (or output) lead 330. Transistor package 300b includes package insulator 340 and protective cover 350. Transistor package 300b may be 1.0 x 1.0 in. square in dimension, although it could have any other suitable dimensions. Each lead 310, 311, 312, 313, 320 and 330, however, is not configured to be of the same approximate size and shape. For example, some of the leads, in this case input lead 320 and output lead 330, may be configured to be slightly longer in length than the other leads 310-313. The periphery of leads 310, 311, 312, 313, 320 and 330 may be soldered to a PCB with tin lead (SnPb) solder and brazed to the package insulator 340 with copper silver (CuAg) brazing. Leads 310, 311, 312, 313, 320 and 330 may also include at least one solder lock 360. Each solder lock 360 may be strategically placed to improve surface contact of leads 310, 311, 312, 313, 320 and 330 to the PCB and to increase the periphery of transistor package 300b, thereby adding mechanical strength at the interface of the leads 310, 311, 312, 313, 320 and 330 to the PCB. Also, mechanical strength at the interface of the leads 310, 311, 312, 313, 320 and 330 to the package insulator 340 is gained by redistributing and reducing mechanical stresses. Thus, the reliability of transistor package 300b is also improved. In addition, improvements in high power density applications, where high power dissipation results in thermal cycling of the entire assembly and exhibits severe mechanical stress upon the soldered and brazed lead frame interfaces, are also achieved.

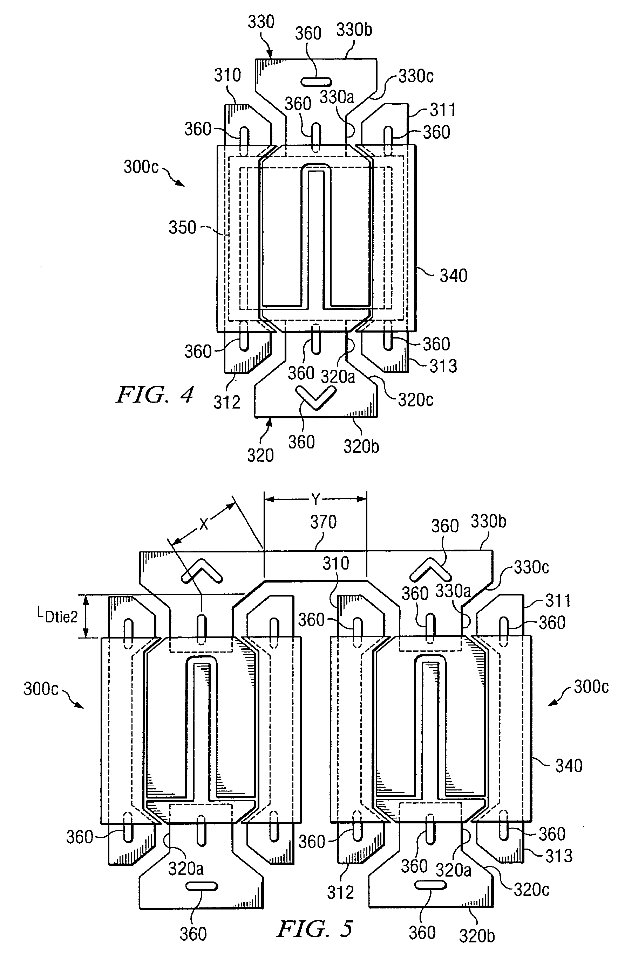

FIGURES 3C and 4 illustrate yet another example transistor package 300c according to a third embodiment of this disclosure. Transistor package 300c typically houses a power semiconductor having four source (or common) lead 310, 311, 312 and 313, gate (or input) lead 320, and drain (or output) lead 330. Transistor package 300c includes package insulator 340 and protective cover 350. Transistor package 300c may be 1.0 x 1.0 in. square in dimension, although it could have any other suitable dimensions. In this example, the leads 310, 311, 312, 313, 320 and 330 may exhibit various sizes and shapes. For example, output lead 330 may include: (1) a near end 330a capable of being brazed to package insulator 340; (2) an elongated far end 330b connectable to a tie point 370; and (3) a tapered region 330c between near end 330a and far end 330b. Tapered region 330c may exhibit symmetrically tapered edges as depicted in FIGURE 3C and 4 or other tapered edges. Output lead 330 may have a greater length than that of leads 310 and 311.

Similarly, input lead 320 may include: (1) a near end 320a capable of being brazed to package insulator 340; (2) an elongated far end 320b connectable to a tie point; and (3) a tapered region 320c between near end 320a and far end 320b. Tapered region 320c may exhibit symmetrically tapered edges as depicted in FIGURE 3C and 4 or other tapered edges. Input lead 320 may have a greater length than that of leads 312 and 313.

The periphery of leads 310, 311, 312, 313, 320 and 330 in transistor package 300c may be soldered to a PCB with tin lead (SnPb) solder and brazed to the package insulator 340 with copper silver (CuAg) brazing. Leads 310, 311, 312, 313, 320 and 330 may also include at least one solder lock 360. Each solder lock 360 may be strategically placed to improve surface contact of leads 310, 311, 312, 313, 320 and 330 to the PCB and to increase the periphery of transistor package 300c, thereby adding mechanical strength at the interface of the leads 310, 311, 312, 313, 320 and 330 to the PCB. Also, mechanical strength at the interface of the leads 310, 311, 312, 313, 320 and 330 to the package insulator 340 is gained by redistributing and reducing mechanical stresses. Thus, the reliability of transistor package 300c is also improved. In addition, improvements in high power density applications, where high power dissipation results in thermal cycling of the entire assembly and exhibits severe mechanical stress upon the soldered and brazed lead frame interfaces, are also achieved.

In practice, applications may require that two high power density transistor packages 300c be electrically connected (i.e., perhaps in parallel) and placed adjacent to one another as closely as is physically possible on a PCB. FIGURE 5 illustrates the physical dimensions and relative proximity of two adjacently placed high power density transistor packages 300c. The distance ($D_{mid2}$) between the centers of the output leads 330 of the two transistor packages 300c (i.e., X + Y + X) is approximately 1.279 in. (where X is 0.358 in. and Y is 0.563 in.). Taking into account any spacing requirements, the minimum lead length to externally connect a high power density transistor package 300c to a tie point 370 ($L_{Dtie2}$) is approximately 0.259 in. Thus, the total path length ($L_{Dlead2}$) required to connect the output lead 330 of a first transistor package 300c to the output lead of a second transistor package 300c is determined using Equation 2:

$$L_{Dlead2} = 2\ L_{Dtie2} + D_{mid2} = 2 * (0.259\ in.) + 1.279\ in. = 1.797\ in.\quad (2)$$

TABLE 1 below summarizes the pertinent electrical paths and periphery lengths for both prior art transistor package 100 and transistor package 300c.

**TABLE 1**

| Length | Prior Art Transistor Package 100 (inches) | Transistor Package 300c (inches) | Optimization (percentage) |
|---|---|---|---|
| $L_{Dlead}$ | 2.550 | 1.797 | -29.5% |
| $P_{Dlead}$ | 1.235 | 2.807 | +127% |
| $P_{Dbraze}$ | 0.445 | 0.534 | +20% |
| $P_{Slead}$ | 4.760 | 4.280 | -10% |
| $P_{Sbraze}$ | 4.230 | 4.944 | +18% |

As shown in TABLE 1, the minimum lead length to externally connect a device to an adjacent device using transistor package 300c is $L_{Dlead2}$ = 1.797 in. compared to $L_{Dlead1}$ = 2.550 in. for prior art transistor package 100. Transistor package 300c decreases, for example, the relative electrical length between adjacent transistor packages by approximately 30%. The resulting decrease in physical length for transistor package 300c contributes proportionally to a decrease in inductance, thereby presenting less impedance to the flow of electrical current as the operating frequency increases. The same holds true for transistor package 300b. Of course, the physical lengths are relative to the distance one device is situated from the adjacent device, but the distance between each device may be dictated by a design specification.

Optimizing or decreasing the physical length or electrical path between two transistor packages may also help to improve frequency response. Optimizing lead layout in accordance with the present disclosure reduces, for example, the electrical length by placing external circuitry physically closer to the transistor contacts. Thus, for example, transistor packages 300b and 300c, in accordance with the present disclosure, may substantially increase frequency response when compared to known configurations.

Optimizing or increasing the edge periphery of transistor lead frames may also generally increase reliability. Transistor packages 300a, 300b and 300c exhibit a periphery greater than that of prior art transistor package 100. The addition of soldering locks 360 also contributes to greater lead periphery. The total length of the edge periphery of output lead 330 available for soldering, which includes the additional length gained by the total contribution of corresponding solder locks, is $P_{Dlead}$= 2.807 in., a 127% increase over the prior art transistor package 100. The same holds approximately true for input lead 320. Thus, the mechanical strength of the solder and braze joints is increased, thereby improving reliability. In addition to increasing the edge periphery, the improved lead design provides improved surface contact by reducing the occurrence of voiding. Voiding typically occurs when attaching lead frames to the PCB during solder reflow operations. During such reflow operations, entrapped materials (such as flux) easily flow when solder is in a liquid state to regions of less compression and less surface tension (such as those now facilitated by the solder locks) in accordance with an embodiment of this disclosure.

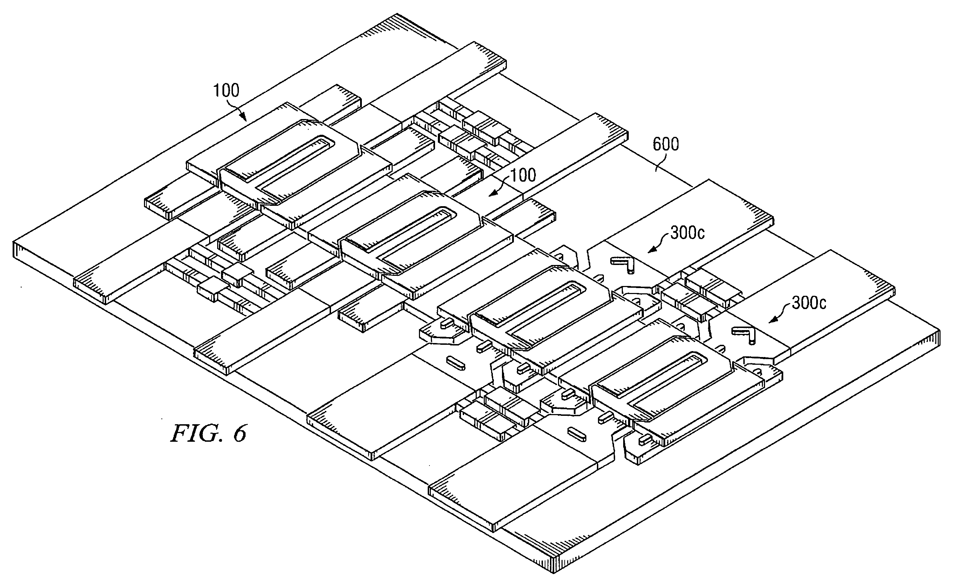

Transistor packages 300a, 300b, 300c and other transistor packages in accordance with the present disclosure may be used in a variety of applications, such as high power amplifiers. There are several advantages to the use of transistor packages in accordance with the present disclosure over prior art transistor packages. FIGURE 6 depicts two prior art transistor packages 100 and two transistor packages 300c according to one embodiment of this disclosure mounted on a PCB 600 in a typical application. FIGURE 6 indeed illustrates, for example, that the physical electrical length between adjacent transistor packages 300c is decreased when compared to the same of prior art transistors 100. Thus, overall inductance in the system is decreased, thereby improving the frequency response of the system.

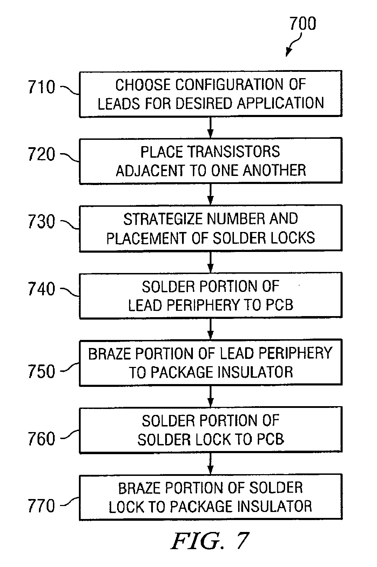

FIGURE 7 illustrates an example method 700 of using the high power density transistor packages 300a, 300b and 300c according to one embodiment of this disclosure. For example, the process may begin in Step 710 by choosing a configuration of the leads of a transistor package for a given application. For example, if a given application requires both increased mechanical strength and improved frequency response over that of the prior art, a configuration similar to transistor package 300b or 300c may be chosen. Designers concerned with increasing only the mechanical strength may opt for a configuration similar to transistor package 300a.

A given application may require transistors to be placed in parallel with one another, effectively doubling the power available from an amplifier. In such cases, the application generally requires that the distance between adjacent transistors be minimized to improve the overall frequency response. Method 700 may thus continue by placing two transistors (with, for example, transistor package 300b or 300c) adjacent to one another on a PCB in Step 720. Also in step 720, a designer may strategize the configuration of the lead geometries to achieve certain application goals and to optionally improve the overall frequency response of the system. In Step 730, a designer may strategize the number and placement of solder locks as desired for a given application. Step 740 may include soldering a portion of the transistor packages' lead periphery to a PCB to increase mechanical strength and reliability. Step 750 may include soldering a portion of a solder lock onto the PCB to further increase mechanical strength and reliability. Continuing on in accordance with the present disclosure, Step 760 may include brazing a portion of the transistor lead periphery to a transistor package insulator, thus further increasing mechanical strength and reliability. Finally, method 700 may include brazing a portion of the solder lock to the transistor package insulator to further improve the mechanical strength and reliability of the transistor in Step 770. The above-referenced steps may be conducted in any order or repeated for any number of transistors as desired.

With the above understanding and goals, it is possible to optimize a geometry where similar results could be obtained but are within the scope of this disclosure. For example, although descriptions for transistor packages 300a, 300b and 300c are included herein, it should be understood that other preferred embodiments may exhibit other configurations, shapes and dimensions.

It may be advantageous to set forth definitions of certain words and phrases used in this patent document. The term "couple" and its derivatives refer to any direct or indirect communication between two or more elements, whether or not those elements are in physical contact with one another. The terms "include" and "comprise," as well as derivatives thereof, mean inclusion without limitation. The term "or" is inclusive, meaning and/or. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like.

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A high power density transistor structure comprising:

   a transistor package capable of housing a high power density transistor, the transistor package having a package insulator and a plurality of transistor leads, wherein each of the transistor leads has a far end, a near end and a lead periphery; and
   a solder lock located on at least one of the transistor leads, wherein at least a portion of the solder lock is attachable to a printed circuit board (PCB);
   wherein at least a portion of the lead periphery of each transistor lead is attachable to at least one of:

      the PCB; and
      the package insulator.

2. The transistor structure of Claim 1, wherein the far end of at least one transistor lead has a width approximately equal to or greater than a width of the near end of the transistor lead.

3. The transistor structure of Claim 1 or 2, wherein at least one of the transistor leads has a length equal to or greater than a length of at least one other transistor lead.

4. The transistor structure of any preceding Claim, wherein at least a portion of the transistor lead periphery of at least one transistor lead is soldered to the PCB, or brazed to the package insulator.

5. The transistor structure of any preceding Claim, wherein at least a portion of the solder lock is attachable to the package insulator.

6. The transistor structure of Claim 5, wherein the solder lock is brazed to the package insulator.

7. The transistor structure of any preceding Claim, wherein the transistor is used in a high power amplifier.

8. The transistor structure of any preceding Claim, further comprising a plurality of solder locks of different shapes.

9. A method for increasing frequency response and mechanical integrity of a high power density transistor having a plurality of leads, the method comprising:

soldering a portion of a transistor lead periphery of at least one of the leads to a printed circuit board (PCB);
soldering a portion of a solder lock of at least one of the leads onto the PCB; and
brazing a portion of the transistor lead periphery of at least one of the leads to a transistor package insulator.

10. The method of Claim 9, further comprising brazing a portion of the solder lock to the transistor package insulator.

11. The method of Claim 9 or 10, wherein each lead has a near end and a far end.

12. The method of Claim 11, wherein the far end of at least one transistor lead has a width approximately equal to or greater than a width of the near end of the transistor lead.

13. The method of Claim 11 or 12, wherein a length of at least one transistor lead is greater than a length of at least one other transistor lead.

14. The method of any of preceding Claims 9 to 13, wherein at least one of:

a width of a far end of a first of the transistor leads is greater than a width of a near end of the first transistor lead; and
a width of a far end of a second of the transistor leads is greater than a width of a near end of the second transistor lead.

15. The method of any of Claims 9 to 14, further comprising at least one of:

brazing the solder lock to the package insulator; and
brazing the lead periphery of at least one of the leads to the package insulator.

16. A high power density transistor structure comprising:

a first transistor package capable of housing a first high power density transistor, the first transistor package having a first package insulator and a plurality of first transistor leads; and
a second transistor package capable of housing a second high power density transistor, the second transistor package having a second package insulator and a plurality of second transistor leads;
wherein each of the first and second transistor leads has a far end, a near end and a lead periphery, the far end of at least one transistor lead having a width greater than a width of the near end of the transistor lead; and
wherein the transistors are electrically connected by the far ends of at least one lead from the first transistor package and at least one lead from the second transistor package.

**FIG. 1**
*(PRIOR ART)*

**FIG. 2**
*(PRIOR ART)*

FIG. 3A

FIG. 3B

FIG. 3C

FIG. 4

FIG. 5

FIG. 6

700

| 710 | CHOOSE CONFIGURATION OF LEADS FOR DESIRED APPLICATION |
| --- | --- |
| 720 | PLACE TRANSISTORS ADJACENT TO ONE ANOTHER |
| 730 | STRATEGIZE NUMBER AND PLACEMENT OF SOLDER LOCKS |
| 740 | SOLDER PORTION OF LEAD PERIPHERY TO PCB |
| 750 | BRAZE PORTION OF LEAD PERIPHERY TO PACKAGE INSULATOR |
| 760 | SOLDER PORTION OF SOLDER LOCK TO PCB |
| 770 | BRAZE PORTION OF SOLDER LOCK TO PACKAGE INSULATOR |

*FIG. 7*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 680727 P